# NEUE EUROPÄISCHE PATENTSCHRIFT

(11) **EP 1 761 729 B2**
(45) Veröffentlichungstag und Bekanntmachung des Hinweises auf die Entscheidung über den Einspruch: **18.05.2022**
(45) Hinweis auf die Patenterteilung: 20.02.2019
(21) Anmeldenummer: 05739863.8
(22) Anmeldetag: 26.04.2005
(51) Int. Cl.: F24C 7/08, G06K 9/00, H03K 17/96, H03K 17/945

(54) **HAUSHALTSGERÄT AUFWEISEND EINE STELLVORRICHTUNG**
DOMESTIC APPLIANCE WITH ADJUSTING DEVICE
APPAREIL MÉNAGER AVEC DISPOSITIF DE RÉGLAGE

(30) Priorität: 28.04.2004 DE 102004020824
(43) Veröffentlichungstag der Anmeldung: 14.03.2007
(73) Patentinhaber: BSH Hausgeräte GmbH, 81739 München (DE)
(72) Erfinder: HUBER, Johann, 83334 Inzell (DE); SCHNELL, Wolfgang, 83308 Trostberg (DE); UNTERREINER, Christian, 83404 Ainring (DE)
(86) Internationale Anmeldenummer: PCT/EP2005/051861
(87) Internationale Veröffentlichungsnummer: WO 2005/106335

(56) Entgegenhaltungen:
- EP-A- 1 158 838
- EP-A- 1 273 851
- EP-A- 1 505 350
- EP-A- 1 517 089
- EP-A1- 0 823 683
- WO-A-03/077100
- WO-A1-03/027942
- WO-A2-02/061693
- DE-A1- 10 133 823
- DE-A1- 10 236 960
- DE-A1- 19 903 919
- ES-A1- 2 168 967
- US-A- 4 855 550
- PATENT ABSTRACTS OF JAPAN Bd. 007, Nr. 266 (P-239), 26. November 1983 (1983-11-26) & JP 58 147670 A (TOKYO SHIBAURA DENKI KK), 2. September 1983 (1983-09-02)

## Beschreibung

Die Erfindung geht insbesondere aus von einem Haushaltsgerät, aufweisend eine Stellvorrichtung mit einem zumindest zweidimensionalen Sensorbereich und mit einer Recheneinheit, die dazu vorgesehen ist, zumindest eine von einer Bedienerposition unterschiedliche Kenngröße bei der Einstellung und/oder einer Umschaltung der Einstellgröße zu berücksichtigen nach dem Oberbegriff des Anspruchs 1.

Aus der EP 1 273 851 A2 ist eine Stellvorrichtung für Gargeräte mit einem von einem Stellstreifen gebildeten berührungsempfindlichen zweidimensionalen Sensorbereich bekannt. Eine Einstellung einer Einstellgröße erfolgt abhängig von einer Berührposition auf dem Stellstreifen, während eine Umschaltung zwischen verschiedenen Modi durch vorbestimmte Berührungszeiten erreichbar ist.

DE 199 03 919 A1 offenbart ein elektrisch betriebenes Haushaltgerät mit einem Eingabemittel. Das Eingabemittel, durch dessen Betätigung die elektrische Ausrüstung des Haushaltgerätes oder ein Teil derselben eingeschaltet wird, ist mit einer Erkennungseinrichtung verbunden, die den Fingerabdruck der Betätigungsperson lesen und erkennen kann, wenn der Fingerabdruck der Betätigungsperson in einem Speicher der Erkennungseinrichtung abgelegt ist, und die nach der Wiedererkennung eines Fingerabdrucks beim Vergleich mit einem oder mehreren im Speicher abgelegten Fingerabdrücken die Einschaltung der elektrischen Ausrüstung oder eines Teils derselben veranlasst.

DE 102 36 960 A1 offenbart ein zugangskontrollierbares Gargerät, wobei mindestens ein Mittel zur Erfassung biometrischer Daten, insbesondere von Fingerabdrücken, Ohrabdrücken, von Aufnahmen des Auges, wie der Iris, und/oder von Aufnahmen des Gesichts oder Ausschnitten davon, wobei das Mittel zur Erfassung biometrischer Daten mit besagtem Gargerät direkt oder indirekt in Wirkverbindung steht, sowie ein Verfahren zum Betreiben eines zugangskontrollierbaren Gargerätes.

WO 2002/061693 A2 offenbart ein Verfahren und eine Vorrichtung zur Eingabe von Steuerungsinformationen in ein Hausgerät, wobei eine biometrische Erkennung eines jeweiligen Anwenders insbesondere anhand eines Fingerabdrucks durchgeführt wird, sowie ein Steuerungssystem. Um ein Verfahren, eine dementsprechende Vorrichtung und ein Steuerungssystem weiterzubilden, wird vorgeschlagen, dass ein Anwender durch die biometrische Erkennung einer von mehreren Benutzer und/ oder Berechtigungsebenen zugeordnet wird.

WO 03/077100 offenbart ein Haushaltsgerät nach dem Oberbegriff des Anspruchs 1.

Die Aufgabe der Erfindung besteht insbesondere darin, eine Stellvorrichtung eines gattungsgemäßen Haushaltsgeräts mit gesteigerter Anwenderfreundlichkeit bereitzustellen. Die Aufgabe wird jeweils durch die Merkmale des Anspruchs 1 gelöst, während vorteilhafte Ausgestaltungen und Weiterbildungen der Erfindung den Unteransprüchen entnommen werden können.

Die Erfindung geht aus von einem Haushaltsgerät, aufweisend eine Stellvorrichtung mit wenigstens einem zumindest zweidimensionalen Sensorbereich zur Einstellung wenigstens einer Einstellgröße.

Die Stellvorrichtung umfasst eine Recheneinheit, die dazu vorgesehen ist, zumindest eine von einer Bedienerposition abweichende Kenngröße bei der Einstellung / oder einer Umschaltung der Einstellgröße zu berücksichtigen. Die von einer Bedienerposition abweichende sensierte Kenngröße kann dabei zusätzlich oder alternativ zur Bedienerposition berücksichtigt werden. Es kann vorteilhaft eine auf einem hohen Informationsgehalt basierende und damit besonders anwenderfreundliche Einstellung erreicht werden. Zudem kann aufgrund dem hohen Informationsgehalt eine Bauraumreduktion erreicht und es können gleichzeitig sowohl große als auch kleine Stufensprünge einfach realisiert werden. Als Einstellgröße kommen insbesondere Leistung, Temperatur, Druck, Feuchtigkeit, Umluftstärke, Lichtstärke usw. in Betracht. In diesem Zusammenhang soll unter einem zumindest zweidimensionalen Sensorbereich ein insbesondere von einer reinen Stelltaste, einem reinen Stellrad oder einem reinen Drehschalter abweichendes Stellmittel verstanden werden, bei dem insbesondere dessen im Wesentlichen zum Bediener weisende Flächenerstreckung zur effektiven Einstellung vorgesehen ist, und zwar insbesondere mittels bezogen auf eine Fläche nebeneinander angeordnete Sensorteilbereiche. Zudem soll unter bei der Einstellung" verstanden werden, dass die Kenngröße insbesondere zeitlich unmittelbar bei der Veränderung der Einstellgröße berücksichtigt wird.

Zudem ist die Kenngröße abhängig von einer zur Betätigung verwendeten Zahl der Finger.

Ferner sind mit zunehmender Anzahl der verwendeten Finger größer werdende Einstellsprünge und/oder Umschaltsprünge realisierbar. Zusätzlich kann die verwendete Anzahl der Finger eines Bediener selbst zu einer bestimmten Schaltung führen, beispielsweise indem bei der Verwendung von einem Finger ein erste Kochplatte ausgewählt und durch eine Bewegung des Fingers eine von der ersten Kochplatte abgegebene Leistung eingestellt werden kann und bei der Verwendung von zwei Fingern eine zweite Kochplatte ausgewählt und durch eine Bewegung der Finger eine von der zweiten Kochplatte abgegebene Leistung eingestellt werden kann usw. Ferner könnten einer Verwendung von mehreren Fingern weitere, dem Fachmann als sinnvoll erscheinende Funktionen und/oder Betriebsarten zugeordnet sein, wie beispielsweise könnte einer Verwendung von zwei Fingern eine automatische Zuschaltung einer Bräterzone zugeordnet sein usw.

Das Haushaltsgerät kann ein Gargerät sein.

Ferner wird ein Haushaltsgerät, insbesondere ein Gargerät, mit wenigstens einem zumindest zweidimensionalen Sensorbereich zur Einstellung wenigstens einer Einstellgröße vorgeschlagen, das eine Recheneinheit umfasst, die dazu vorgesehen ist, zumindest eine von einer Bedienerverweildauer abweichende Kenngröße bei einer Umschaltung zu berücksichtigen. Die von einer Bedienerverweildauer abweichende Kenngröße kann dabei zusätzlich oder alternativ zur Bedienerverweildauer berücksichtigt werden. Es kann wiederum vorteilhaft eine auf einem hohen Informationsgehalt basierende und damit besonders anwenderfreundliche Umschaltung erreicht und es kann eine Bauraumreduktion erzielt werden.

Die Kenngröße oder Größen zur Ermittlung der Kenngröße werden vorzugsweise mit einer Sensoreinheit der Stellvorrichtung sensiert, können jedoch auch von einer bzgl. der Stellvorrichtung externen Sensoreinheit sensiert und anschließend der Stellvorrichtung über eine Datenleitung zugeführt sein, wie beispielsweise über einen CAN-Bus (CAN: Controller Area Network), wodurch zusätzliche Sensoren, Montageaufwand und Kosten eingespart werden können.

Ist die Kenngröße im Hinblick auf die Einstellung zumindest abhängig von einer Zeitdauer, können konstruktiv einfach und kostengünstig zusätzliche Informationen gewonnen werden, die flexibel zur Einstellung genutzt werden können.

Besonders vorteilhaft ist die Kenngröße zumindest abhängig von einer dynamischen Größe und insbesondere zumindest abhängig von einer Bedienerbewegungsgeschwindigkeit, wodurch einfach eine gut einprägsame und zumindest weitgehend selbsterklärende, intuitive Einstellung als auch Umschaltung realisierbar ist, und zwar insbesondere, wenn mit zunehmender Bedienerbewegungsgeschwindigkeit größere Einstellsprünge und/oder auch Umschaltsprünge, beispielsweise durch Auslassen zumindest einzelner Zwischenschritte, realisiert werden. Die zumindest von der Bedienerbewegungsgeschwindigkeit abhängige Kenngröße und/oder Größen zur Ermittlung derselben können dabei vorteilhaft durch Erfassung einer Zeitdauer ermittelt werden. Grundsätzlich können diese jedoch auch durch andere Größen, wie beispielsweise durch die Höhe eines von einer Bedienerbewegungsgeschwindigkeit abhängigen Spannungsausschlags einer induktiven Schaltung usw., ermittelt werden.

Zusätzlich oder alternativ zu einer zumindest von einer Bedienerbewegungsgeschwindigkeit abhängigen Kenngröße kann eine erfasste Zeitdauer vorteilhaft dazu genutzt werden, eine von einer Bedienerverweildauer abhängige Einstellung zu realisieren. Die Einstellung kann dabei mit stetigen Einstellsprüngen und/oder mit sich mit der Bedienerverweildauer verändernden Einstellsprüngen realisiert sein. Vorzugsweise können mit zunehmender Bedienerverweildauer größer werdende Einstellsprünge realisiert sein.

In einer nicht unter die Erfindung fallenden Ausgestaltung kann anstelle einer durch Verwendung einer unterschiedlichen Anzahl von Fingern veränderte Auflagefläche auch eine durch einen Auflagedruck eines einzelnen und/oder auch mehrerer Finger sich verändernde Auflagefläche von einer Sensoreinheit erfasst und von der Recheneinheit berücksichtigt sein. Ein Bedienerauflagedruck kann jedoch auch vorteilhaft mittels eines Drucksensors erfasst und zur Einstellung und/oder Umschaltung genutzt werden, beispielsweise indem mit zunehmendem Bedienerauflagedruck größere Einstellsprünge, Umschaltsprünge und/oder direkt weitere Funktionen, wie die Zuschaltung einer Bräterzone usw., realisiert sind.

In einer weiteren Ausgestaltung der Erfindung wird vorgeschlagen, dass die Kenngröße zumindest abhängig von einer bedienerindividuellen Größe ist. Die Einstellung und/oder Umschaltung kann dadurch ganz individuell an einen bestimmten Bediener angepasst werden. Zudem können von individuellen Gegebenheiten bedingte Fehleinstellungen und/oder Umschaltungen vermieden werden, beispielsweise kann bei einer zumindest von einer Bedienerauflagefläche abhängigen Kenngröße ein Einfluss von unterschiedlichen Handgrößen verschiedener Bediener eliminiert werden, so dass stets eine entsprechende Betätigung mit einem und/oder mit mehreren Fingern bei unterschiedlichen Bedienern mit unterschiedlichen Handgrößen dennoch zum gleichen Einstellergebnis und/oder Umschaltergebnis führt. Ferner kann mit einer Kenngröße, die zumindest abhängig von einer bedienerindividuellen Größe ist, die Einstellung und/oder Umschaltung zumindest teilweise blockiert werden, wodurch ein erhöhter Sicherheitsstandard erreicht werden kann. Beispielsweise können unterschiedlich alten Kindern unterschiedliche Freigaben erteilt werden, so dass beispielsweise einem vierzehnjährigen Kind sämtliche elektrische Kochstellen und der Backofen freigegeben wird, jedoch keine Gaskochstellen, und einem zehnjährigen Kind nur eine einzige elektrische Kochstelle und diese nur bis zu einer bestimmten Leistungsstufe und möglicherweise mit zusätzlich zugeordneten Sicherungsfunktionen, beispielsweise einer automatischen Abschaltung nach einer bestimmten Zeitdauer usw. Die Kenngröße oder Größen zur Ermittlung derselben können dabei mittels einem Fingerabdruckscanner, einem Netzhautscanner usw. sensiert werden.

Ist die Kenngröße zumindest abhängig von einer Bedienerbewegungsrichtung, können weitere komfortable Einstellmöglichkeiten und/oder Umschaltmöglichkeiten erzielt werden. Dabei kann eine Bedienerbewegungsrichtung mittels einer Sensoreinheit nur hinsichtlich einer Dimension oder vorteilhaft hinsichtlich zweier Dimensionen oder hinsichtlich dreier Dimensionen erfasst und ausgewertet werden. Soll die Bewegungsrichtung hinsichtlich zweier Dimensionen erfasst werden, kann beispielsweise ein flächiges Sensorfeld vorgesehen sein, mittels dem Kenngrößen für beliebige Bewegungsrichtungen eines Bedieners auf dem Sensorfeld sensierbar sind. Das flächige Sensorfeld kann dabei verschiedene, dem Fachmann als sinnvoll erscheinende Formen aufweisen, beispielsweise kann dieses rund, oval, vieleckig usw. ausgeführt sein. Soll die Bewegungsrichtung hinsichtlich dreier Dimensionen erfasst werden, kann beispielsweise ein absenkbares, flächiges Sensorfeld vorgesehen sein, um eine Bedienerbewegungsrichtung hinsichtlich dreier Dimensionen zu erfassen.

Ist der zumindest zweidimensionalen Sensorbereich berührungsempfindlich ausgebildet, kann auf einfache, kostengünstige Sensoren zurückgegriffen werden.

Die Stellvorrichtung kann mit einer bereits für eine andere Funktionseinheit vorgesehenen Speichereinheit verbunden sein, die zur Speicherung eines zur Einstellung und/oder Umschaltung relevanten Parameters genutzt werden kann, wodurch zusätzliche Bauteile, Montageaufwand und Kosten eingespart werden können, oder kann vorteilhaft selbst mit einer Speichereinheit ausgestattet sein, wodurch die Speichereinheit auf die Anforderungen der Stellvorrichtung vorteilhaft ausgelegt werden kann. Ferner kann die Stellvorrichtung als in sich zumindest weitgehend eigenständige Einheit hergestellt, programmiert und auf ihre Funktion überprüft werden. In der Speichereinheit können neben erforderlichen Daten für die Einstellung und/oder die Umschaltung selbst auch andere, dem Fachmann als sinnvoll erscheinende Daten gespeichert sein, beispielsweise Daten für eine Kochautomatik usw.

Zudem kann das erfindungsgemäße Haushaltsgerät zusätzlich zum zumindest zweidimensionalen Sensorbereich zumindest ein Extremwertstellbereich zur Einstellung eines Extremwerts umfassen. Eine Funktionseinheit kann dadurch direkt auf einen Extremwert ohne Zwischenschritte eingestellt werden, beispielsweise auf eine maximale Leistungsabgabe oder auf eine minimale Leistungsabgabe, wodurch der Komfort weiter gesteigert werden kann.

Ferner kann das erfindungsgemäße Haushaltsgerät eine Recheneinheit umfassen, die dazu vorgesehen ist, bei einer Nacheinstellung zumindest eine von einer Bedienerausgangsposition abweichende Kenngröße zu berücksichtigen. Eine Abhängigkeit der Nacheinstellung von einer Bedienerausgangsposition beim Start der Nacheinstellung kann zumindest reduziert und besonders vollständig vermieden werden, wenn die Recheneinheit zur Ausschließung der Bedienerausgangsposition im Hinblick ihres Einflusses auf die Nacheinstellung vorgesehen ist.

In einer weiteren Ausgestaltung der Erfindung wird vorgeschlagen, dass das Haushaltsgerät eine Recheneinheit umfasst, die dazu vorgesehen ist, bei wenigstens einer Bedienerwiederholaktion eine Umschaltung einzuleiten, wodurch einfach weitere Schaltfunktionen integriert werden können. Dabei können Umschaltvorgänge beispielsweise durch mehrfaches Antippen, mehrfaches Überstreichen usw. realisiert sein.

Weist das Haushaltsgerät eine Sprachausgabeeinheit auf, mittels der einem Bediener Informationen über die Einstellung und/oder Umschaltung akustisch, sprachlich mitgeteilt werden können, kann der Komfort des Haushaltsgerät weiter gesteigert werden. Ferner kann eine Komfortsteigerung erzielt werden, indem das Haushaltsgerät eine von einer Bildschirmeinheit gebildete Ausgabeeinheit aufweist, die vorzugsweise zur Wiedergabe von Farbbildern vorgesehen ist. Dabei soll unter einer Bildschirmeinheit insbesondere eine Einheit verstanden werden, mittels der Bilder zumindest weitgehend ohne bestimmte Formvorgaben wiedergegeben werden können.

Das erfindungsgemäße Haushaltsgerät eignet sich für verschiedene, dem Fachmann als sinnvoll erscheinende Anwendungsbereiche, jedoch besonders für Gargeräte, wie Backöfen, Kochmulden, Mikrowellenherde usw., bei denen mittels einer entsprechenden Stellvorrichtung vorteilhafte Reinigungsbedingungen und damit die Voraussetzungen für einen besonders hygienischen Betrieb geschaffen werden können. Ferner kann eine besonders intuitive Bedienung sichergestellt werden.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
Fig. 1 einen Backofen mit einer Kochmulde schräg von der Seite,
Fig. 2 einen vergrößerten Ausschnitt eines zweidimensionalen Sensorbereichs aus Fig. 1,
Fig. 3 einen ersten alternativen zweidimensionalen Sensorbereich,
Fig. 4 einen zweiten alternativen zweidimensionalen Sensorbereich,

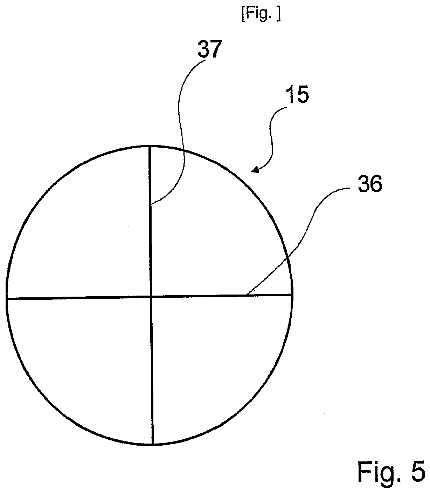

Fig. 5 einen vergrößerten Ausschnitt eines weiteren zweidimensionalen Sensorbereichs aus Fig. 1,
Fig. 6 ein dreidimensionaler Sensorbereich aus Fig. 1 in einer Draufsicht und
Fig. 7 ein Diagramm von Einstellsprüngen insbesondere über einer Bedienerbewegungsgeschwindigkeit.

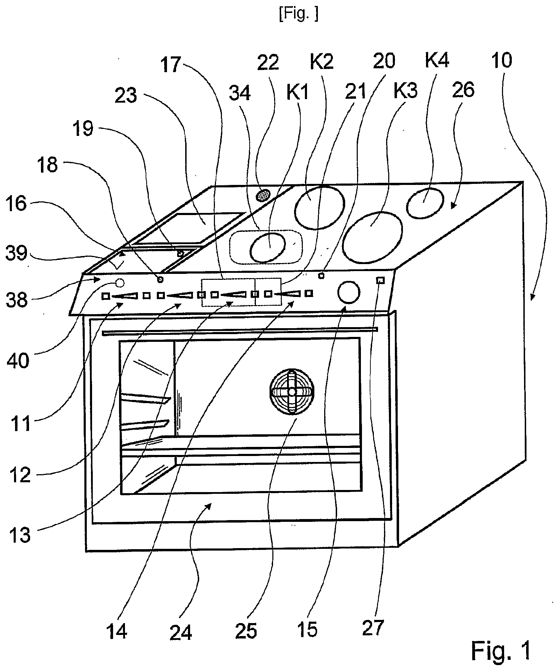

Figur 1 zeigt einen Herd 10, der einen Backofen 24 mit einer Backofenmuffel 25 und eine Kochmulde 26 mit vier Kochstellen K1, K2, K3, K4 aufweist. Der Herd 10 weist eine erfindungsgemäße Stellvorrichtung auf, die für jede Kochstelle K1, K2, K3, K4 einen zweidimensionalen Sensorbereich 11, 12, 13, 14, einen zweidimensionalen Sensorbereich 15 zur Einstellung einer Garzeit und einen dreidimensionalen Sensorbereich 16 für den Backofen 24 umfasst. Mittels denen an einer schräg nach oben weisenden Frontseite angeordneten Sensorbereichen 11, 12, 13, 14 kann insbesondere jeweils eine von den Kochstellen K1, K2, K3, K4 abgegebene Leistung eingestellt werden. Mittels dem im Randbereich einer Deckseite des Herds 10 angeordneten Sensorbereich 16 kann eine Umschaltung zwischen verschiedenen Backfunktionen und eine Einstellung einer Garleistung vorgenommen werden.

Stellt sich ein Bediener unmittelbar vor den Herd 10, wird dies entweder über zwei an der Frontseite und/oder über einen an der Deckseite angeordneten Bewegungssensor 18, 19, 20 erfasst und die Stellvorrichtung über eine Recheneinheit 17 in eine Bereitschaftsstellung versetzt. In dieser Bereitschaftsstellung wird die Frontseite im Bereich der Sensorbereiche 11, 12, 13, 14, 15 und die Deckseite im Bereich des Sensorbereichs 16 beleuchtet. Will der Bediener anschließend eine Einstellung über die Stellvorrichtung vornehmen, muss sich dieser zuerst identifizieren, indem er seinen Zeigefinger auf einen Fingerabdruckscanner 27 an der Frontseite legt. Die erfassten Daten werden anschließend mit in einer Speichereinheit 21 der Stellvorrichtung bei einer ersten Inbetriebnahme abgelegten Datensätzen verglichen. Ist der Herd 10 für den Bediener gesperrt, beispielsweise ist der Bediener ein minderjähriges Kind, kann von diesem keine Einstellung, keine Umschaltung bzw. Auswahl über die Stellvorrichtung vorgenommen werden.

Ist der Herd 10 für den Bediener freigegeben, kann dieser über die Sensorbereiche 11, 12, 13, 14 die von den Kochstellen K1, K2, K3, K4 abgegebene Heizleistung einstellen. Nachfolgend wird die Funktion des Sensorbereichs 11 erläutert, der baugleich mit den Sensorbereichen 12, 13, 14 ausgeführt ist, bezüglich denen bis auf eine Bräterzonenzuschaltung auf die Beschreibung zum Sensorbereich 11 verwiesen werden darf.

Der Sensorbereich 11 ist über einen horizontal ausgerichteten, länglichen Keil gekennzeichnet und ist berührungsempfindlich ausgebildet. Unter dem länglichen Keil ist eine piezotechnische Sensoreinheit angeordnet. Anstelle einer piezotechnischen Sensoreinheit sind jedoch auch andere Sensoreinheiten denkbar, wie beispielsweise kapazitive, induktive, optische und/oder thermische Sensoreinheiten usw.

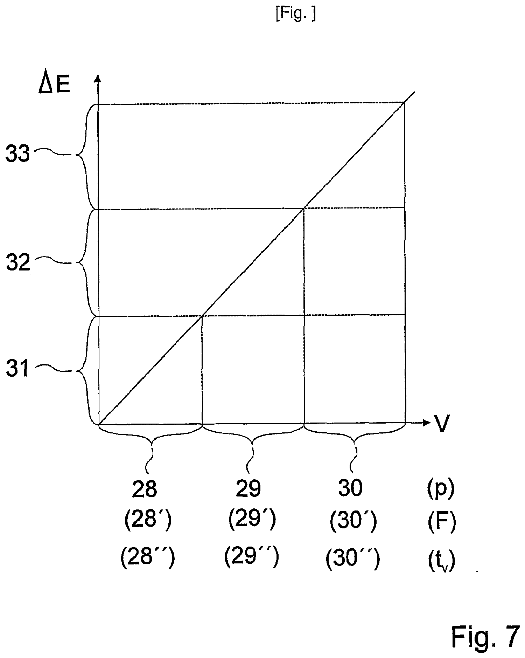

Verfährt der Bediener mit einem auf den Sensorbereich 11 aufgelegten Finger von links nach rechts wird mit zunehmender Wegstrecke eine höhere Leistungsstufe eingestellt. Dabei ist die Recheneinheit 17 dazu vorgesehen, bei der Einstellung auftretende Einstellsprünge _{Δ}E abhängig von einer Bedienerbewegungsgeschwindigkeit v auszuwählen. Eine vorliegende Leistungsspanne der Kochstelle K1 ist in neun Stufen eingeteilt. Liegt die Bedienerbewegungsgeschwindigkeit v in einem unteren Geschwindigkeitsbereich 28, wird die Leistung in einem ersten Einstellsprungbereich 31 bei einer Bewegung des Bedieners von links nach rechts jeweils um eine Stufe erhöht und bei einer Bewegung von rechts nach links jeweils um eine Stufe reduziert (Fig. 7). Liegt die Bedienerbewegungsgeschwindigkeit v in einem zweiten Geschwindigkeitsbereich 29, wird die Leistung in einem zweiten Einstellsprungbereich 32 bei einer Bewegung des Bedieners von links nach rechts jeweils um zwei Stufen erhöht und bei einer Bewegung von rechts nach links jeweils um zwei Stufen reduziert. Liegt die Bedienerbewegungsgeschwindigkeit v in einem dritten Geschwindigkeitsbereich 30, wird die Leistung in einem dritten Einstellsprungbereich 33 bei einer Bewegung des Bedieners von links nach rechts jeweils um drei Stufen erhöht und bei einer Bewegung von rechts nach links jeweils um drei Stufen reduziert.

Ferner liegt eine entsprechende Abhängigkeit zwischen einem Bedienerauflagedruck p und einer Bedienerauflagefläche F vor, d.h. einem ersten Druckbereich 28' ist der erste Einstellsprungbereich 31, einem zweiten, höheren Druckbereich 29' ist der zweite Einstellsprungbereich 32 und einem dritten, höchsten Druckbereich 30' ist der dritte Einstellsprungbereich 33 zugeordnet und einem ersten Flächenbereich 28" ist der erste Einstellsprungbereich 31, einem zweiten, größeren Flächenbereich 29" ist der zweite Einstellsprungbereich 32 und einem dritten, größten Flächenbereich 30" ist der dritte Einstellsprungbereich 33 zugeordnet. Der erste Flächenbereich 28" ist dabei der Bedienung mit einem Finger, der zweite Flächenbereich 29" ist dabei der Bedienung mit zwei Fingern und der dritte Flächenbereich 30" ist dabei der Bedienung mit drei Fingern zugeordnet. Um zu vermeiden, dass es bei einem Bediener mit einer großen Handfläche zu einer anderen Einstellung kommt als bei einem Bediener mit einer kleinen Handfläche, sind die Flächengrößen individuellen Bedienern zugeordnet. Bei einer ersten Inbetriebnahme werden die jeweils unterschiedlichen Flächengrößen pro Bediener erfasst. Identifiziert sich der Bediener bei einem anschließenden Betrieb, wird der diesem Bediener zugeordnete Datensatz verwendet, indem abgelegt ist, wie groß bei diesem speziellen Bediener die Auflagefläche F von einem, von zwei und von drei Fingern ist.

Ist die maximale Leistungsstufe 9 eingestellt und wird vom Bediener eine Bedienerwiederholaktion ausgeführt, indem erneut mit einem, mit zwei oder mit drei Fingern auf dem Sensorbereich 11 von links nach rechts verfahren wird, wird ein Ankochstoß ausgelöst.

Ferner kann eine Umschaltung bzw. eine Hinzuschaltung und Abschaltung einer Bräterzone 34 über den Sensorbereich 11 erreicht werden, indem der Bediener auf dem Sensorbereich 11 mit einer von drei Fingern gebildeten Bedienerauflagefläche F länger als fünf Sekunden verweilt. Die Umschaltung ist damit neben einer Bedienerverweildauer abhängig von einer Bedienerauflagefläche F.

Die Recheneinheit 17 ist zur Ausschließung der Bedienerausgangsposition im Hinblick ihres Einflusses auf eine Nacheinstellung vorgesehen, d.h. ist eine Heizleistung eingestellt und soll diese bei einer Nacheinstellung verändert werden, ist die Nacheinstellung unabhängig von einer erneuten Auflagestelle des Bedieners. Vielmehr findet eine Nacheinstellung nur abhängig von einer sich an die Auflage eines oder mehrerer Finger anschließenden Bewegung nach links oder rechts statt.

Dem Sensorbereich 11 sind zudem zwei Extremwertstellbereiche min, max zur Einstellung von Extremwerten zugeordnet. Durch Berühren des Extremwertstellbereichs min kann unmittelbar die minimale Leistungsstufe 1 und durch Berühren des Extremwertstellbereichs max kann unmittelbar die maximale Leistungsstufe 9 eingestellt werden.

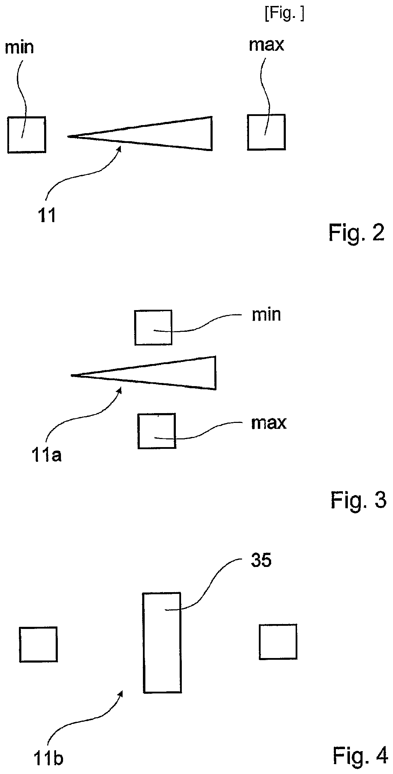

Der Extremwertstellbereich min ist in einer Bewegungsrichtung von einer kleinen Leis-tungsstufte zu einer hohen Leistungsstufe von links nach rechts vor dem Sensorbereich 11 und der Extremwertstellbereich max ist nach dem Sensorbereich 11 angeordnet. Die Extremwertstellbereiche min, max könnten jedoch auch an anderen, dem Fachmann als sinnvoll erscheinenden Stellen angeordnet sein, beispielsweise über und unter einem dem Sensorbereich 11 entsprechenden Sensorbereich 11a (Fig. 3).

Die eingestellte Leistungsstufe der jeweiligen Kochstelle K1, K2, K3, K4 wird über einen von einem Lautsprecher einer Sprachausgabeeinheit 22 akustisch und über eine Flachbildschirmeinheit 23 optisch ausgegeben, die beide im Randbereich der Deckseite angeordnet und mit einer schützenden Glasplatte abgedeckt sind. Die Flachbildschirmeinheit 23 ist dabei zur Wiedergabe von Farbbildern vorgesehen. Die Recheneinheit 17 ist zudem ans Internet anschließbar, so dass über die Flachbildschirmeinheit 23 neben Informationen über die ausgewählten Garmodi und eingestellten Einstellgrößen usw. auch Internetseiten angezeigt und auch Fernsehprogramme ausgestrahlt werden können.

Alternativ zu dem Sensorbereich 11 kann ein Sensorbereich 11b mit einer integrierten Siebensegmentanzeigeeinheit 35 versehen sein, wie dies in Figur 4 dargestellt ist. Grundsätzlich wäre jedoch auch denkbar, eine Anzeigeeinheit, beispielsweise eine Siebensegmentanzeigeeinheit, neben einem Sensorbereich zu positionieren.

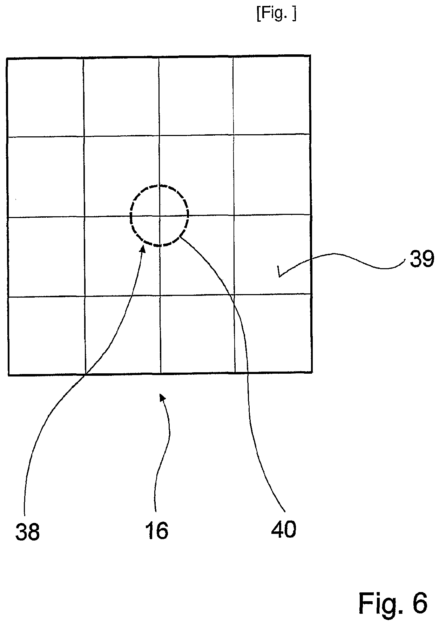

Dem Sensorbereich 16 ist eine nicht erfindungsgemäßen Sensoreinheit 38 zur berührungslosen Betätigung zugeordnet, die eine unterhalb einer Glasplatte 39 angeordnete Kamera 40 aufweist (Fig. 1 und 6). Ferner weist die Sensoreinheit 38 eine nicht näher dargestellte Lichtquelle in einer ebenfalls nicht näher dargestellten Abzugshaube auf, die von oben auf den Sensorbereich 16 gerichtet ist.

Zur Aktivierung des Sensorbereichs 16 führt der Bediener seine gesamte Handfläche mit gestreckten und geschlossenen Fingern in den Sensorbereich 16 über die Kamera 40 und verweilt mindestens drei Sekunden. Mittels der Kamera 40 wird ein Schattenwurf der Handfläche des Bedieners erfasst und nach Ablauf der drei Sekunden wird mittels der Recheneinheit 17 der Sensorbereich 16 zur Einstellung und Umschaltung aktiviert.

Nach der Aktivierung des Sensorbereichs 16 kann der Bediener mit vorgegebenen Zeichen und damit verbundenen unterschiedlichen, von der Kamera 40 erfassten Schattenwürfen verschiedene Betriebsarten auswählen bzw. zwischen verschiedenen Betriebsarten umschalten. Winkelt der Bediener bis auf den Zeigefinger sämtliche Finger im Sensorbereich 16 ab, wird dadurch eine erste Betriebsart ausgewählt, und zwar die durch einen Umluftbetrieb gekennzeichnete Betriebsart. Winkelt der Bediener bis auf den Zeigefinger und Mittelfinger alle Finger ab und spreizt die gestreckten Finger, wird eine zweite Betriebsart ausgewählt, und zwar die durch eine Oberhitze gekennzeichnete Betriebsart. Winkelt der Bediener Daumen und Zeigefinger ab und spreizt die gestreckten Mittelfinger, Ringfinger und Kleinenfinger, wird eine dritte Betriebsart ausgewählt, und zwar die durch Unterhitze gekennzeichnete Betriebsart. Winkelt der Bediener nur den Daumen ab und spreizt die restlichen Finger, wird eine vierte Betriebsart ausgewählt, und zwar die durch einen Grillbetrieb gekennzeichnete Betriebsart. Streckt der Bediener im Sensorbereich 16 sämtliche Finger und spreizt diese, wird eine fünfte Betriebsart ausgewählt, und zwar die durch Unterhitze, Oberhitze und Umluft gekennzeichnete Betriebsart. Wird innerhalb von fünf Sekunden nach der Auswahl einer Betriebsart ein weiteres Zeichen vom Bediener gegeben, wird eine weitere Betriebsart in Kombination zu der ersten gewählten Betriebsart aktiviert. Zur Deaktivierung sämtlicher ausgewählter Betriebsarten winkelt der Bediener sämtliche Finger ab bzw. formt seine Hand im Sensorbereich 16 zu einer Faust. Grundsätzlich ist auch denkbar, dass die entsprechenden Zeichen von einem Bediener in individuelle Zeichen geändert werden können.

Ist eine Betriebsart ausgewählt, kann der Bediener mittels dem Sensorbereich 16 die Heizleistung berührungslos einstellen. Verfährt der Bediener mit ausgestrecktem Zeigefinger von links nach rechts, wird mit zunehmender Wegstrecke eine höhere Leistungsstufe eingestellt, und zwar indirekt indem vom Bediener eine Zieltemperatur in der Backofenmuffel 25 eingestellt wird. Dabei ist die Recheneinheit 17 dazu vorgesehen, bei der Einstellung auftretende Einstellsprünge abhängig von einer Bedienerbewegungsgeschwindigkeit v auszuwählen. Liegt die Bedienerbewegungsgeschwindigkeit in einem unteren Geschwindigkeitsbereich und bewegt der Bediener seine Hand mit bis auf den Zeigefinger abgewinkelten Fingern von links nach rechts, wird die Zieltemperatur in der Backofenmuffel 25 jeweils um Fünfgradstufensprünge erhöht. Bewegt der Bediener die Hand entsprechend von rechts nach links, wird die Zieltemperatur in Fünfgradstufensprüngen reduziert. Liegt die Bedienerbewegungsgeschwindigkeit in einem zweiten höheren Geschwindigkeitsbereich und bewegt der Bediener seine Hand mit bis auf den Zeigefinger abgewinkelten Fingern von links nach rechts, wird die Zieltemperatur in der Backofenmuffel 25 jeweils um Zehngradstufensprünge erhöht. Bewegt der Bedienerdie Hand entsprechend von rechts nach links, wird die Zieltemperatur in Zehngradstufensprüngen reduziert. Liegt die Bedienerbewegungsgeschwindigkeit in einem dritten höchsten Geschwindigkeitsbereich und bewegt der Bediener seine Hand mit bis auf den Zeigefinger abgewinkelten Fingern von links nach rechts, wird die Zieltemperatur in der Backofenmuffel 25 jeweils um Zwanziggradsprünge erhöht. Bewegt der Bediener die Hand entsprechend von rechts nach links, wird die Zieltemperatur in Zwanziggradsprüngen reduziert.

Streckt der Bediener bei der Einstellung der Heizleistung zusätzlich zum Zeigefinger den Mittelfinger, werden die Gradsprünge im Verhältnis zu einer Einstellung mit nur gestrecktem Zeigefinger verdoppelt.

Der Sensorbereich 15 ist durch eine kreisförmige Fläche gekennzeichnet. Unterhalb der kreisförmigen Fläche ist eine berührungsempfindliche, piezotechnische Sensoreinheit angeordnet. Anstelle einer piezotechnischen Sensoreinheit sind jedoch auch andere Sensoreinheiten denkbar, wie beispielsweise kapazitive, induktive, optische und/oder thermische Sensoreinheiten usw.

Ist eine der Kochstellen K1, K2, K3, K4 oder der Backofen 24 aktiviert, kann unmittelbar nach deren Aktivierung mittels dem Sensorbereich 15 eine Garzeit eingestellt werden, in der die entsprechende Kochstelle K1, K2, K3, K4 bzw. der Backofen 24 mit der eingestellten Heizleistung betrieben werden soll. Verfährt der Bediener mit einem auf den Sensorbereich 15 aufgelegten Finger von links nach rechts wird mit zunehmender Weg-strecke eine längere Garzeit eingestellt. Dabei ist die Recheneinheit 17 dazu vorgesehen, bei der Einstellung auftretende Einstellsprünge abhängig von einer Bedienerbewegungsrichtung auszuwählen. Je flacher der Bediener seinen Finger bezogen zu eine horizontalen Achse 36 bewegt, umso größere Einstellsprünge werden durchgeführt. Dadurch kann mit einer horizontalen Bewegung über den Sensorbereich 15 eine Grobeinstellung mit großen Einstellsprüngen und eine Feineinstellung mit einer Bewegung nahe an einer im Wesentlichen vertikal verlaufenden Achse 37 erzielt werden. Zusätzlich kann eine Garzeit eingestellt werden, indem der Bediener mit seinem Finger auf dem Sensorbereich 15 verweilt. Verweilt der Bediener im von der Achse 37 rechten Bereich, nimmt die Garzeit zu, verweilt der Bediener im von der Achse 37 linken Bereich, nimmt die Garzeit ab.

### Bezugszeichen

**Tabelle 1**

| | | | |
|---|---|---|---|
| 10 | Haushaltsgerät | 31 | Einstellsprungbereich |
| 11 | Sensorbereich | 32 | Einstellsprungbereich |
| 12 | Sensorbereich | 33 | Einstellsprungbereich |
| 13 | Sensorbereich | 34 | Bräterzone |
| 14 | Sensorbereich | 35 | Siebensegmentanzeigeeinheit |
| 15 | Sensorbereich | 36 | Achse |
| 16 | Sensorbereich | 37 | Achse |
| 17 | Recheneinheit | 38 | Sensoreinheit |
| 18 | Sensoreinheit | 39 | Glasplatte |
| 19 | Sensoreinheit | 40 | Kamera |
| 20 | Sensoreinheit | | |
| 21 | Speichereinheit | v | Bedienerbewegungsgeschwindigkeit |
| 22 | Sprachausgabeeinheit | F | Bedienerauflagefläche |
| 23 | Bildschirmeinheit | p | Bedienerauflagedruck |
| 24 | Backofen | min | Extremwertstellbereich |
| 25 | Backofenmuffel | max | Extremwertstellbereich |
| 26 | Kochmulde | K1 | Kochstelle |
| 27 | Fingerabdruckscanner | K2 | Kochstelle |
| 28 | Geschwindigkeitsbereich | K3 | Kochstelle |
| 28' | Druckbereich | K4 | Kochstelle |
| 28" | Flächenbereich | _{Δ}E | Einstellsprung |
| 29 | Geschwindigkeitsbereich | | |
| 29' | Druckbereich | | |
| 29" | Flächenbereich | | |
| 30 | Geschwindigkeitsbereich | | |
| 30' | Druckbereich | | |
| 30" | Flächenbereich | | |

## Patentansprüche

1. Haushaltsgerät (10), aufweisend eine Stellvorrichtung mit wenigstens einem zumindest zweidimensionalen berührungsempfindlichen Sensorbereich (11, 12, 13, 14, 15, 16) zur Einstellung wenigstens einer Einstellgröße und mit einer Recheneinheit (17), die dazu vorgesehen ist, zumindest eine von einer Bedienerposition unterschiedliche Kenngröße bei der Einstellung und/oder einer Umschaltung der Einstellgröße zu berücksichtigen, wobei die Kenngröße eine von einer zur Betätigung verwendeten Zahl der Finger abhängige Bedienerauflagefläche (F) ist, **dadurch gekennzeichnet, dass** mit zunehmender Anzahl der verwendeten Finger größer werdende Einstellsprünge und/oder Umschaltsprünge realisierbar sind.

2. Haushaltsgerät (10) nach Anspruch 1, **dadurch gekennzeichnet, dass** das Haushaltsgerät (10) ein Gargerät ist.

3. Haushaltsgerät (10) nach einem der vorhergehenden Ansprüche, **dadurch gekennzeichnet, dass** die verwendete Anzahl der Finger zu einer bestimmten Schaltung mit zunehmender Anzahl der verwendeten Finger führt.

4. Haushaltsgerät (10) nach einem der vorhergehenden Ansprüche, **dadurch gekennzeichnet, dass** bei einer Verwendung von mehreren Fingern bestimmte Funktionen und/oder Betriebsarten zugeordnet sind.

5. Haushaltsgerät (10) nach einem der vorhergehenden Ansprüche, **gekennzeichnet durch** eine Recheneinheit (17), die dazu vorgesehen ist, zumindest eine von einer Bedienerverweildauer abweichende Kenngröße bei einer Umschaltung zu berücksichtigen.

6. Haushaltsgerät (10) nach einem der vorhergehenden Ansprüche, **dadurch gekennzeichnet, dass** die Kenngröße zumindest abhängig von einem Bedienerauflagedruck (p) ist.

7. Haushaltsgerät (10) nach einem der vorhergehenden Ansprüche, **dadurch gekennzeichnet, dass** die Kenngröße zumindest abhängig von einer bedienerindividuellen Größe ist.

8. Haushaltsgerät (10) nach einem der vorhergehenden Ansprüche, **gekennzeichnet durch** eine Speichereinheit (21) zur Speicherung wenigstens eines Parameters.

9. Haushaltsgerät (10) nach einem der vorhergehenden Ansprüche, **dadurch gekennzeichnet, dass** zusätzlich zum zumindest zweidimensionalen Sensorbereich (11, 12, 13, 14, 15, 16) zumindest ein Extremwertstellbereich (min, max) zur Einstellung eines Extremwerts vorgesehen ist.

10. Haushaltsgerät (10) nach einem der vorhergehenden Ansprüche, **gekennzeichnet durch** eine Recheneinheit (17), die dazu vorgesehen ist, bei einer Nacheinstellung zumindest eine von einer Bedienerausgangsposition abweichende Kenngröße zu berücksichtigen.

11. Haushaltsgerät (10) nach Anspruch 10, **dadurch gekennzeichnet, dass** die Recheneinheit (17) zur Ausschließung der Bedienerausgangsposition im Hinblick ihres Einflusses auf die Nacheinstellung vorgesehen ist.

12. Haushaltsgerät (10) nach einem der vorhergehenden Ansprüche, **gekennzeichnet durch** eine Recheneinheit (17), die dazu vorgesehen ist, bei wenigstens einer Bedienerwiederholaktion eine Umschaltung einzuleiten.

13. Haushaltsgerät (10) nach einem der vorhergehenden Ansprüche, **gekennzeichnet durch** eine Sprachausgabeeinheit (22).

14. Haushaltsgerät (10) nach einem der vorhergehenden Ansprüche, **gekennzeichnet durch** eine von einer Bildschirmeinheit (23) gebildeten Ausgabeeinheit.

15. Haushaltsgerät (10) nach Anspruch 14, **dadurch gekennzeichnet, dass** die Bildschirmeinheit (23) zur Wiedergabe von Farbbildern vorgesehen ist.

## Claims

1. Household appliance (10), having an adjusting apparatus with at least one at least two-dimensional touch-sensitive sensor region (11, 12, 13, 14, 15, 16) for setting at least one adjusted variable and with a computing unit (17), which is provided to take into consideration at least one characteristic variable different from an operating position during the setting and/or a switching of the adjusted variable, wherein the characteristic variable is an operator contact surface (F) dependent upon a number of fingers used for actuation, **characterised in that** as the number of fingers used increases, ever greater jumps are able to be realised during the setting and/or switching.

2. Household appliance (10) according to claim 1, **characterised in that** the household appliance (10) is a cooking appliance.

3. Household appliance (10) according to one of the preceding claims, **characterised in that** the number of fingers used leads to a designated circuit as the number of fingers used increases.

4. Household appliance (10) according to one of the preceding claims, **characterised in that** when a plurality of fingers are used, designated functions and/or modes of operation are assigned.

5. Household appliance (10) according to one of the preceding claims, **characterised by** a computing unit (17), which is provided to take into consideration at least one characteristic variable differing from an operator dwell time during a switching.

6. Household appliance (10) according to one of the preceding claims, **characterised in that** the characteristic variable is at least dependent upon an operator contact pressure (p).

7. Household appliance (10) according to one of the preceding claims, **characterised in that** the characteristic variable is at least dependent upon an operator-specific variable.

8. Household appliance (10) according to one of the preceding claims, **characterised by** a memory unit (21) for storing at least one parameter.

9. Household appliance (10) according to one of the preceding claims, **characterised in that** there is provision, in addition to the at least two-dimensional sensor region (11, 12, 13, 14, 15, 16), for at least one extreme value setting region (min, max) for setting an extreme value.

10. Household appliance (10) according to one of the preceding claims, **characterised by** a computing unit (17) which is provided to take into consideration at least one characteristic variable differing from an operator starting position during a subsequent setting.

11. Household appliance (10) according to claim 10, **characterised in that** the computing unit (17) is provided for excluding the operator starting position with respect to its influence on the subsequent setting.

12. Household appliance (10) according to one of the preceding claims, **characterised by** a computing unit (17) which is provided for initiating a switching during at least one operator repeat action.

13. Household appliance (10) according to one of the preceding claims, **characterised by** a speech output unit (22).

14. Household appliance (10) according to one of the preceding claims, **characterised by** an output unit formed by a visual display unit (23).

15. Household appliance (10) according to claim 14, **characterised in that** the visual display unit (23) is provided for rendering colour images.

## Revendications

1. Appareil ménager (10), comprenant un dispositif de réglage doté d'au moins une zone de détection (11, 12, 13, 14, 15, 16) au moins bidimensionnelle sensible au contact pour le réglage d'au moins une grandeur de réglage et d'une unité de calcul (17) conçue pour prendre en compte au moins une grandeur caractéristique dépendant de la position de l'utilisateur lors du réglage et/ou de la commutation de la grandeur de réglage, dans lequel la grandeur caractéristique est associée à une surface de contact d'un utilisateur (F) dépendant du nombre de doigts utilisés pour l'actionnement, **caractérisé en ce qu'**avec un nombre croissant de doigts utilisés, des sauts de réglage et/ou des sauts de commutation croissants peuvent être réalisés.

2. Appareil ménager (10) selon la revendication 1, **caractérisé en ce que** l'appareil ménager (10) est un appareil de cuisson.

3. Appareil ménager (10) selon l'une quelconque des revendications précédentes, **caractérisé en ce que** le nombre de doigts utilisés conduit à un couplage particulier en fonction d'un nombre croissant des doigts utilisés.

4. Appareil ménager (10) selon l'une quelconque des revendications précédentes, **caractérisé en ce que** des fonctions et/ou des modes de fonctionnement déterminés sont affectés en utilisant plusieurs doigts.

5. Appareil ménager (10) selon l'une quelconque des revendications précédentes, **caractérisé par** une unité de calcul (17) conçue pour prendre en compte au moins une grandeur caractéristique dépendant d'une durée de maintien par un utilisateur lors d'une commutation.

6. Appareil ménager (10) selon l'une quelconque des revendications précédentes, **caractérisé en ce que** la grandeur caractéristique dépend d'au moins une pression de contact (p) par l'utilisateur.

7. Appareil ménager (10) selon l'une quelconque des revendications précédentes, **caractérisé en ce que** la grandeur caractéristique dépend d'au moins une grandeur individuelle de l'utilisateur.

8. Appareil ménager (10) selon l'une quelconque des revendications précédentes, **caractérisé par** une unité de mémoire (21) permettant d'enregistrer au moins un paramètre.

9. Appareil ménager (10) selon l'une quelconque des revendications précédentes, **caractérisé en ce qu'**en plus de la zone de détection au moins bidimensionnelle (11, 12, 13, 14, 15, 16), au moins une plage de réglage de valeur extrême (min, max.) pour le réglage d'une valeur extrême est prévue.

10. Appareil ménager (10) selon l'une quelconque des revendications précédentes, **caractérisé par** une unité de calcul (17) qui est conçue pour prendre en compte, lors d'un réglage postérieur, au moins une grandeur caractéristique différente d'une position initiale de l'utilisateur.

11. Appareil ménager (10) selon la revendication 10, **caractérisé en ce que** l'unité de calcul (17) est conçue pour exclure la position initiale de l'utilisateur dans son influence sur le réglage postérieur.

12. Appareil ménager (10) selon l'une quelconque des revendications précédentes, **caractérisé par** une unité de calcul (17) qui est conçue pour engager une commutation lors d'au moins une action de répétition de l'utilisateur.

13. Appareil ménager (10) selon l'une quelconque des revendications précédentes, **caractérisé par** une unité d'émission vocale (22).

14. Appareil ménager (10) selon l'une quelconque des revendications précédentes, **caractérisé par** une unité de sortie constituée d'une unité d'affichage (23).

15. Appareil ménager (10) selon la revendication 14, **caractérisé en ce que** l'unité d'affichage (23) est conçue pour reproduire des images en couleurs.
